# EUROPÄISCHE PATENTSCHRIFT

(11) **EP 3 340 471 B1**
(45) Veröffentlichungstag und Bekanntmachung des Hinweises auf die Patenterteilung: **04.09.2019**
(21) Anmeldenummer: 18150598.3
(22) Anmeldetag: 14.05.2012
(51) Int. Cl.: H03M 1/10, G01R 35/00, G01R 19/25, H03M 1/12

(54) **MESSVORRICHTUNG MIT EINEM SICHEREN MESSKANAL**
MEASURING DEVICE WITH A SECURE MEASURING CHANNEL
DISPOSITIF DE MESURE POURVU DE CANAL DE MESURE SÉCURISÉ

(30) Priorität: 20.05.2011 DE 102011050539
(43) Veröffentlichungstag der Anmeldung: 27.06.2018
(62) Teilanmeldung aus: 12167933.6
(73) Patentinhaber: Phoenix Contact GmbH & Co. KG, 32825 Blomberg (DE)
(72) Erfinder: Rohs, Markus, 32825 Blomberg (DE); Pott, Thomas, 33719 Bielefeld (DE)
(74) Vertreter: Michalski Hüttermann & Partner Patentanwälte mbB

(56) Entgegenhaltungen:
- WO-A1-03/085834
- DE-A1-102005 011 406
- GB-A- 2 145 888

## Beschreibung

Die Erfindung betrifft eine Messvorrichtung mit wenigstens zwei Messkanälen, jeder Messkanal umfassend einen A/D-Wandler für die Umwandlung einer analogen Spannung in einen digitalen Spannungswert, und eine Logikeinheit, die mit dem A/D-Wandler verbunden ist, um den digitalen Spannungswert zu empfangen.

Derartige Messvorrichtungen sind im Stand der Technik bekannt und werden verwendet, um über verschiedene Messsensoren bereitgestellte analoge Spannungen für eine weitere Verarbeitung in einer digitalen Steuereinheit in digitale Spannungswerte umzuwandeln. Als Teil der Umwandlung kann eine Signalverarbeitung in der Messvorrichtung vorgesehen sein, entweder auf Seiten der analogen Spannung oder des digitalen Spannungswerts. In der Praxis wird oft eine Messvorrichtung mit einer Mehrzahl Messkanälen ausgeführt, um eine entsprechende Mehrzahl Sensoren zu überwachen.

Für bestimmte Anwendungsfälle ist es wichtig einen sicheren Messkanal mit einer hohen Zuverlässigkeit bereitzustellen. Aufgrund der Alterung von Bauteilen, Bauteildefekten, äußeren Einflüssen, Schwankungen von Umgebungsparametern und ähnlichem kann es vorkommen, dass der in einem Messkanal vom A/D-Wandler bereitgestellte digitale Spannungswert nicht oder zumindest nicht mit einer hinreichenden Genauigkeit mit der analogen Spannung korrespondiert.

Im Stand der Technik ist beispielsweise bekannt einen überprüfbaren Messkanal bereitzustellen, bei dem ein digitaler Spannungswert von der Logikeinheit mit einer Variation über einen D/A-Wandler als analoge Spannung eingangsseitig an dem A/D-Wandler bereitgestellt wird. Dadurch ist es möglich in der Logikeinheit den digitalen Spannungswert für diese bekannte Referenzspannung mit dem angelegten Signal zu vergleichen und darüber die Funktion des Messkanals zu überprüfen.

Nachteilig hieran ist jedoch, dass diese Überprüfung lediglich einen Plausibilitätsprüfung darstellt. Ein zuverlässiges Überprüfen eines Messkanals ist nicht gewährleistet. Das von der Logikeinheit rückgekoppelte Signal basiert auf dem digitalen Spannungswert, wodurch eine unabhängige Überprüfung der Funktion des Messkanals nicht möglich ist.

In diesem Kontext ist aus der DE 10 2005 011 406 A1 ein Zwei-Kanal-Verfahren zum Ermitteln zumindest eines Ausgangssignals aus sich ändernden Eingangssignalen, welche von einem Geber herrühren, bekannt. Entsprechend werden zwei voneinander unabhängige Kanäle bereitgestellt. Die Eingangssignale werden abwechselnd diesen Kanälen zugeführt, wobei ein Multiplexer zum Umschalten zwischen den Kanälen dient. Ein Mikroprozessor in einem der Kanäle stellt Testeingangssignale bereit, welche dem Kanal zugeführt werden, an dem die sich ändernden Eingangssignale gegenwärtig nicht anliegen. Entsprechend gibt dieser Kanal Ausgangssignale aus, welche mit einem Erwartungswert verglichen werden, um zu prüfen, ob dieser Kanal korrekt arbeitet. Gleichzeitig dient der andere Kanal zur Herstellung des Ausgangssignals. Anschließend wird von dem Multiplexer aufgrund eines Steuersignals umgeschaltet. Dabei ist in jedem Kanal ein A/D-Wandler angeordnet, welcher die analoge Messspannung in einen digitalen Spannungswert umwandelt. Dem Mikrocontroller ist ein D/A Wandler nachgeschaltet, um den Erwartungswert als analoges Signal bereitzustellen.

Ausgehend von diesem Stand der Technik ist es Aufgabe der vorliegenden Erfindung, eine Messvorrichtung der oben genannten Art bereitzustellen, bei der ein Messkanal einfach und zuverlässig auf seine Funktion überprüft werden kann.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Erfindungsgemäß ist somit eine Messvorrichtung mit den Merkmalen des vorliegenden Anspruchs 1 angegeben.

Erfindungsgemäß ist somit insbesondere eine Messvorrichtung mit wenigstens zwei Messkanälen vorgesehen, jeder Messkanal umfassend einen A/D-Wandler für die Umwandlung einer analogen Spannung in einen digitalen Spannungswert, und eine Logikeinheit, die mit dem A/D-Wandler verbunden ist, um den digitalen Spannungswert zu empfangen, wobei wenigstens ein Messkanal als sicherer Messkanal mit einer hohen Zuverlässigkeit ausgeführt ist und einen Multiplexer aufweist, wobei mit dem Multiplexer die analoge Spannung zwischen einer Messspannung und einer Referenzspannung umschaltbar ist, die Logikeinheit jedes sicheren Messkanals als Referenzerzeuger für wenigstens einen anderen sicheren Messkanal ausgeführt ist, um die Referenzspannung bereitzustellen und den Multiplexer zwischen der Messspannung und der Referenzspannung umzuschalten, und die Logikeinheit des wenigstens einen anderen sicheren Messkanals und der Referenzerzeuger miteinander verbunden und derart ausgeführt sind, dass ein digitaler Wert, der die Referenzspannung repräsentiert, von dem Referenzerzeuger an die Logikeinheit des sicheren Messkanals übertragbar ist und die Logikeinheit des sicheren Messkanals ausgeführt ist, ihren digitalen Spannungswert mit einem übertragenen digitalen Wert zu vergleichen.

In anderen Worten ist der Kerngedanke der vorliegenden Erfindung eine Messvorrichtung bereitzustellen, bei der der Eingang eines Messkanals zwischen der Messspannung und der Referenzspannung umschaltbar ist. Die Referenzspannung wird unabhängig von dem zu überprüfenden Messkanal erzeugt, nämlich von der Logikeinheit eines zweiten Messkanals, der aufgrund dieser zusätzlichen Funktion als Referenzerzeuger bezeichnet wird. Der Referenzerzeuger kann derart mit dem Multiplexer verbunden sein, dass er nicht nur die Referenzspannung bereitstellt, sondern auch das Umschalten des Multiplexers bewirkt. Alternativ erfolgt diese Umschaltung über die Logikeinheit des sicheren Messkanals.

Die Logikeinheit des sicheren Messkanals ist ausgeführt, den mit der angelegten Referenzspannung korrespondierenden digitalen Wert mit dem von dem Referenzerzeuger übermittelten digitalen Wert zu vergleichen, und die Überprüfung des Messkanals durchzuführen. Der digitale Spannungswert des Referenzerzeugers dient also als Erwartungswert für die Überprüfung des sicheren Messkanals, der mit dem digitalen Wert des sicheren Kanals als Istwert verglichen wird. Anhand des Ergebnisses des Vergleichs wird die Funktion des sicheren Messkanals überprüft und damit sichergestellt. Unabhängig von dem Vergleich kann die Ansteuerung des Multiplexers von dem Referenzerzeuger oder von der Logikeinheit des sicheren Messkanals durchgeführt werden.

In vorteilhafter Ausgestaltung der Erfindung ist vorgesehen, dass der Multiplexer integral mit dem A/D-Wandler als eine Eingangseinheit ausgeführt ist. Bevorzugt umfasst die Messvorrichtung weitere Komponenten zur analogen oder digitalen Signalverarbeitung, die integral oder separat zu dem A/D-Wandler ausgeführt sein können. Beispielsweise können solche Komponenten als Verstärker oder Filter ausgeführt sein.

Gemäß einer bevorzugten Ausführungsform der vorliegenden Erfindung ist vorgesehen, dass der Referenzerzeuger ausgeführt ist, die Referenzspannung basierend auf einem Zufallswert bereitzustellen. Somit wird die Unabhängigkeit der an dem A/D-Wandler des zu überprüfenden Messkanals bereitgestellten Referenzspannung erhöht. Insbesondere bei wiederholter Überprüfung des sicheren Messkanals kann ein umfassender Bereich erlaubter Eingangswerte für die analoge Spannung überprüft werden. Fehler, die nur in einem bestimmten Bereich der analogen Spannung auftreten, können somit zuverlässig detektiert werden.

In bevorzugter Ausgestaltung der Erfindung ist vorgesehen, dass wenigstens zwei Messkanäle als sichere Messkanäle ausgeführt sind und die Logikeinheit wenigstens eines sicheren Messkanals als Referenzerzeuger für wenigstens einen anderen sicheren Messkanal ausgeführt ist. In anderen Worten ist vorgesehen, dass wenigstens bei einem sicheren Messkanal die Logikeinheit als Referenzerzeuger für einen weiteren Messkanal ausgeführt ist. Insbesondere können alle Messkanäle als sichere Messkanäle ausgeführt sein, so dass die Messvorrichtung insgesamt nur sichere Messkanäle aufweist. Dabei können die Logikeinheiten aller Messkanäle als Referenzerzeuger dienen, um andere sichere Messkanäle zu überprüfen, oder es kann vorgesehen sein, dass die Logikeinheiten von mindestens zwei Messkanälen als Referenzerzeuger dienen. In diesem Fall stellt jeder Referenzerzeuger die Referenzspannung für den jeweils anderen Messkanal zur Verfügung, und weitere sichere Messkanäle sind mit einem der Referenzerzeuger verbunden. In einer bevorzugten Ausführungsform ist vorgesehen, dass der Multiplexer ausgeführt ist, mit mehreren Referenzspannungen verschiedener Referenzerzeuger verbunden zu werden, um eine Redundanz bereitzustellen. Prinzipiell ist es möglich, dass jeder Referenzerzeuger mit jedem Multiplexer aller anderen sicheren Messkanäle verbunden ist. Entsprechend können die sicheren Messkanäle überprüft werden, ohne dass zusätzliche Komponenten, insbesondere separate Referenzerzeuger erforderlich sind.

Gemäß einer bevorzugten Ausführungsform der vorliegenden Erfindung ist vorgesehen, dass der Referenzerzeuger eine programmierbare Spannungsquelle für die Bereitstellung der Referenzspannung umfasst. Dadurch kann die Referenzspannung auf einfache Weise von dem Referenzerzeuger bereitgestellt werden. Vorzugsweise ist die programmierbare Spannungsquelle mit einer digitalen Schnittstelle zur Programmierung ausgeführt, und der Referenzerzeuger ist ausgeführt, eine digitale Ansteuerung der programmierbaren Spannungsquelle vorzunehmen. Die Ausgangsspannung der programmierbaren Spannungsquelle kann unmittelbar als Referenzspannung bereitgestellt werden, oder es wird eine von der Ausgangsspannung der programmierbaren Spannungsquelle abgeleitete Spannung als Referenzspannung bereitgestellt.

Gemäß einer bevorzugten Ausführungsform der vorliegenden Erfindung umfasst die Messvorrichtung einen einstellbaren Spannungsteiler und der Referenzerzeuger ist ausgeführt, durch Einstellung des Spannungsteilers die Referenzspannung bereitzustellen. Der Spannungsteiler kann an eine beliebige Spannung der Messvorrichtung angeschlossen sein. Vorzugsweise ist der Referenzerzeuger integral mit dem Spannungsteiler ausgeführt. Der Spannungsteiler kann auf sich bekannter Weise aufgebaut sein. Insbesondere ist eine Kombination mit einer programmierbaren Spannungsquelle möglich, wobei die Ausgangsspannung der programmierbaren Spannungsquelle durch den Spannungsteiler geteilt wird. Die Messvorrichtung kann bei mehreren Referenzerzeugern wenigstens einen gemeinsamen Spannungsteiler umfassen, oder mit separaten Spannungsteilern für jeden Referenzerzeuger ausgeführt sein.

Weiterhin kann vorgesehen sein, dass der Spannungsteiler mehrfach einstellbar ist und eine Mehrzahl Referenzerzeuger ausgeführt ist, durch Einstellung des Spannungsteilers die Referenzspannung bereitzustellen. Dabei kann vorgesehen sein, dass jeder Referenzerzeuger oder wenigstens eine Mehrzahl Referenzerzeuger das Teilungsverhältnis des Spannungsteilers beeinflusst, um die Referenzspannung unabhängig von einem einzelnen Referenzerzeuger bereitzustellen. Weiterhin können gleichzeitig mehrere Referenzspannungen an dem Spannungsteiler abgegriffen werden, um eine Mehrzahl sicherer Messkanäle zu überprüfen.

Gemäß einer vorteilhaften Ausgestaltung der Erfindung ist vorgesehen, dass der Referenzerzeuger einen D/A-Wandler umfasst und ausgeführt ist, an dem D/A-Wandler die Referenzspannung basierend auf einem digitalen Wert bereitzustellen. Der digitale Wert kann auf einfache Weise in dem Referenzerzeuger bereitgestellt werden, um beliebige erlaubte Spannungswerte für die analoge Spannung abzudecken. Beispielsweise kann ein Zufallsgenerator vorgesehen sein, um in dem Referenzerzeuger den digitalen Wert zu erzeugen. Prinzipiell ist es auch möglich, dass der D/A-Wandler separat zu dem Referenzerzeuger ausgeführt und diesem beigeordnet ist.

Gemäß einer bevorzugten Ausführungsform der vorliegenden Erfindung ist vorgesehen, dass der Referenzerzeuger ausgeführt ist, die Referenzspannung basierend auf dem an ihm anliegenden digitalen Wert bereitzustellen. Beispielsweise kann der digitale Wert unmittelbar verwendet werden, um die Referenzspannung zu erzeugen, oder von dem digitalen Wert wird ein Wert abgeleitet, aus dem die Referenzspannung bereitgestellt wird. Beispielsweise ist es möglich, Zufallswerte zu dem digitalen Wert zu addieren oder davon abzuziehen, um darauf basierend die Referenzspannung zu erzeugen. Dabei ist bevorzugt, dass die Messkanäle des Referenzerzeugers und der zu überprüfende Messkanal möglichst unterschiedliche und/oder unabhängige Sensorgrößen messen. So wird erreicht, dass die Überprüfung des sicheren Messkanals besonders zuverlässig erfolgt. Beispielsweise kann ein Sensor für Temperatur an einem sicheren Messkanal vorgesehen sein, und an dem Messkanal mit dem Referenzerzeuger ist ein Sensor für eine Feuchtigkeit, eine Betriebsspannung oder einen Strom vorgesehen. Eine hohe Unabhängigkeit kann auch erreicht werden, indem gleichartige Sensoren in unabhängigen Bereichen eingesetzt werden, beispielsweise ein Sensor für eine Innentemperatur in dem sicheren Messkanal und ein Sensor für eine Außentemperatur in dem Messkanal, der den Referenzerzeuger beinhaltet.

Gemäß einer vorteilhaften Ausgestaltung der vorliegenden Erfindung ist vorgesehen, dass die Logikeinheit des sicheren Messkanals und der Referenzerzeuger miteinander verbunden und derart ausgeführt sind, dass der digitale Spannungswert von der Logikeinheit des sicheren Messkanals an den Referenzerzeuger übertragbar ist und der Referenzerzeuger ausgeführt ist, den übertragenen digitalen Spannungswert mit einem digitalen Wert, der die Referenzspannung repräsentiert, zu vergleichen. Auch hier dient der digitale Spannungswert des Referenzerzeugers als Erwartungswert für die Überprüfung des sicheren Messkanals, der mit dem digitalen Wert des sicheren Kanals als Istwert verglichen wird. Anhand des Ergebnisses des Vergleichs wird die Funktion des sicheren Messkanals überprüft und damit sichergestellt. In diesem Ausführungsbeispiel wird die Überprüfung des sicheren Messkanals in dem Referenzerzeuger durchgeführt. Der Referenzerzeuger vergleicht den von der Logikeinheit des sicheren Messkanals erzeugten digitalen Wert, also den auf der an den sicheren Messkanal angelegten Referenzspannung beruhenden Istwert, und den Erwartungswert. Auch hier kann die Ansteuerung des Multiplexers von dem Referenzerzeuger oder von der Logikeinheit des sicheren Messkanals durchgeführt werden.

In beiden Fällen kann das Vergleichsergebnis angezeigt, übertragen oder weiter verarbeitet werden. Beispielsweise weist eine Logikeinheit eine optische oder akustische Fehleranzeige auf, die eine Überschreitung einer Toleranz signalisiert oder den Abweichungswert ausgibt, oder sie führt eine Übertragung an eine übergeordnete Steuereinheit durch, in der das Ergebnis verarbeitet wird. Die übergeordnete Steuereinheit kann beispielsweise integral mit der Logikeinheit eines Messkanals ausgeführt sein.

In bevorzugter Ausgestaltung der Erfindung ist vorgesehen, dass die Messvorrichtung zwischen einem Normalmodus und einem Überprüfungsmodus umschaltbar ist, wobei die Messvorrichtung ausgeführt ist, im Überprüfungsmodus wenigstens einen sicheren Messkanal zu überprüfen. Eine solche Umschaltung kann beispielsweise periodisch durchgeführt werden, oder von außen angestoßen werden. Beispielsweise kann ein Benutzer oder ein Wartungstechniker eine Überprüfung der Messvorrichtung initiieren. Dabei ist es möglich, dass im Überprüfungsmodus eine sequentielle Überprüfung aller sicheren Messkanäle durchgeführt wird, und die übrigen Messkanäle im Normalbetrieb weiter arbeiten. Die Überprüfung eines Messkanals kann derart implementiert sein, dass eine Referenzspannung an dem sicheren Messkanal angelegt und der damit korrespondierende digitale Wert überprüft wird, oder dass eine Überprüfung des sicheren Messkanals mit einer Mehrzahl Referenzspannungen durchgeführt wird. Insbesondere ist es auch möglich, den sicheren Messkanal quasi kontinuierlich über einen Bereich erlaubter analoger Spannungen zu überprüfen.

Nachfolgend wird die Erfindung unter Bezugnahme auf die anliegende Zeichnung anhand bevorzugter Ausführungsformen näher erläutert.

Es zeigen
- Fig. 1: eine Messvorrichtung gemäß einer bevorzugten Ausführungsform der Erfindung in schematischer Ansicht,
- Fig. 2: ein Detail eines Referenzerzeugers mit einem D/A-Wandler in schematischer Ansicht, und
- Fig. 3: einen Spannungsteiler zur Erzeugung von zwei Referenzspannungen in schematischer Ansicht.

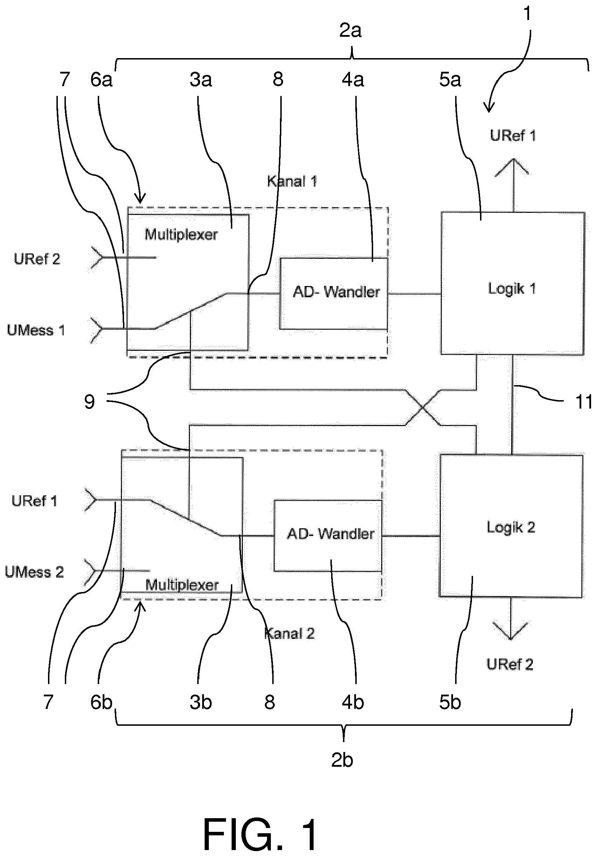

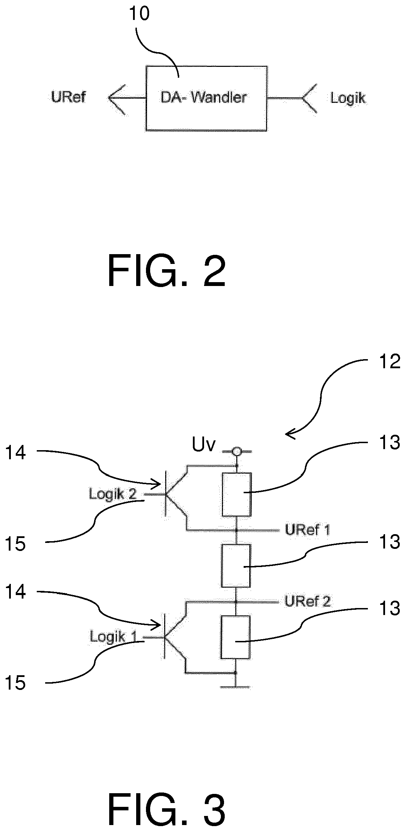

Die Figuren 1 und 2 betreffen eine elektrische Messvorrichtung 1 gemäß einer ersten Ausführungsform der Erfindung. Die Messvorrichtung 1 umfasst zwei Messkanäle 2a, 2b, wie in Figur 1 gezeigt ist. Der in Figur 1 obere, erste Messkanal wird durch das Bezugszeichen 2a gekennzeichnet, der in Figur 1 untere, zweite Messkanal wird durch das Bezugszeichen 2b gekennzeichnet.

Die Messkanäle 2a, 2b sind als sichere Messkanäle ausgeführt und umfassen, wie am Beispiel des ersten, oberen Messkanals 2a erläutert wird, einen Multiplexer 3a, einen A/D-Wandler 4a und eine Logikeinheit 5a. Der Multiplexer 2a und der A/D-Wandler 2b bilden in diesem Ausführungsbeispiel eine Eingangseinheit 6a, die jedoch für die Funktion des Multiplexers 3a und des A/D-Wandlers 4a ohne Bedeutung ist.

Der Multiplexer 3a weist zwei Eingänge 7 auf, die mit zwei analogen Spannungen verbunden sind. Dies sind gemäß Figur 1 eine erste Messspannung U_{Mess1}, die von einem nicht gezeigten ersten Sensor bereitgestellt wird, und eine zweite Referenzspannung U_{Ref2}, auf die später im Detail eingegangen wird. Der Multiplexer 3a ist ausgeführt einen der beiden Eingänge 7 mit seinem Ausgang 8 zu verbinden. Dazu weist der Multiplexer 3a einen Steuerungseingang 9 auf, über den der Multiplexer 3a zwischen den beiden Eingängen 7 umschaltbar ist.

Der A/D-Wandler 4a ist eingangsseitig mit dem Ausgang 8 des Multiplexers 3a verbunden. Entsprechend liegt an dem A/D-Wandlers 4a als analoge Spannung entweder die zweite Referenzspannung U_{Ref2} oder die erste Messspannung U_{Mess1} an. Der A/D-Wandler 4a wandelt die eingangsseitige analoge Spannung in einen digitalen Spannungswert um, der ausgangsseitig zur Übertragung an die Logikeinheit 5a bereitgestellt wird.

Die Logikeinheit 5a des ersten Messkanals 2a empfängt den von dem A/D-Wandler 4a bereitgestellten digitalen Spannungswert zur weiteren Verarbeitung. Außerdem ist die Logikeinheit 5a in diesem Ausführungsbeispiel ausgeführt, um eine Referenzspannung U_{Ref1} zu erzeugen.

Der zweite, in Figur 1 untere Messkanal 2b ist funktionsgleich zu dem ersten, oberen Messkanal 2a mit Multiplexer 3b, A/D-Wandler 4b, die zusammen Eingangseinheit 6b bilden, sowie Logikeinheit 5b ausgeführt, so dass auf weitere Ausführungen zur Funktion verzichtet werden kann. An dem zweiten, unteren Messkanal 2b liegen eingangsseitig eine erste Referenzspannung U_{Ref1} sowie eine zweite Messspannung U_{Mess2} an, die als analoge Spannungen bereitgestellt werden. Die zweite Messspannung U_{Mess2} wird von einem zweiten Sensor, der in den Figuren nicht gezeigt ist, bereitgestellt.

Zur Überprüfung des ersten, oberen Messkanals 2a dient die Logikeinheit 5b des zweiten, unteren Messkanals 2b als Referenzerzeuger und umgekehrt. Die Logikeinheiten 5a, 5b umfassen jeweils einen D/A-Wandler 10, an den ein digitaler Wert als Erwartungswert angelegt wird, um die Referenzspannungen U_{Ref1}, U_{Ref2} zu erzeugen. Der D/A-Wandler 10 ist in diesem Ausführungsbeispiel integral mit der jeweiligen Logikeinheit 5a, 5b ausgeführt. In diesem Ausführungsbeispiel wird als Erwartungswert an dem D/A-Wandler 10 der an der Logikeinheit 5a, 5b anliegende digitale Wert des A/D-Wandlers 4a, 4b des jeweiligen Messkanals 2a, 2b bereitgestellt.

Der Ausgang des D/A-Wandlers 10 der Logikeinheit 5b des zweiten Messkanals 2b ist wie zuvor beschrieben mit einem Eingang 7 des Multiplexers 3a des ersten Messkanals 2a verbunden, um dort die Referenzspannung U_{Ref2} bereitzustellen. Entsprechend ist die erste Referenzspannung U_{Ref1} der Logikeinheit 5a des ersten Messkanals 2a an einem Eingang 7 des Multiplexers 3b des zweiten Messkanals 2b bereitgestellt. Weiterhin sind die Logikeinheiten 5a, 5b mit dem Steuerungseingang 9 des Multiplexers 3b, 3a des jeweils anderen Messkanals 2b, 2a verbunden. Weiterhin ist zwischen den Logikeinheiten 5a, 5b eine Verbindungsleitung 11 vorgesehen, die in dieser Ausführungsform zur Übertragung des von dem jeweiligen A/D-Wandler 4a, 4b empfangenen digitalen Werts an die jeweils andere Logikeinheit 5b, 5a ausgeführt ist.

In einem Normalmodus ist der Multiplexer 3a, 3b jedes Messkanals 2a, 2b über die Logikeinheit 5b, 5a des jeweils anderen Messkanals 2b, 2a derart geschaltet, dass die jeweilige Messspannung U_{Mess1}, U_{Mess2} eingangsseitig am entsprechenden A/D-Wandler 4a, 4b anliegt. Von dem A/D-Wandler 4a, 4b wird ein digitaler Wert an die jeweilige Logikeinheit 5a, 5b übertragen. Der digitale Wert repräsentiert die jeweils anliegende Messspannung U_{Mess1}, U_{Mess2}.

In einem Überprüfungsmodus wird für jeden Messkanal 2a, 2b individuell eine Überprüfung durchgeführt, was hier wieder in Bezug auf die Überprüfung des ersten, oberen Messkanals 2a im Detail beschrieben wird. Dazu schaltet die Logikeinheit 5b des zweiten, unteren Messkanals 2b über ihre Verbindung mit dem Steuerungseingang 9 den Multiplexer 3a, so dass die zweite Referenzspannung U_{Ref2} eingangsseitig an dem A/D-Wandler 3a anliegt. Die zweite Referenzspannung U_{Ref2} wird wie zuvor beschrieben erzeugt. Der A/D-Wandler 3a führt eine Analog/Digital-Wandlung der zweiten Referenzspannung U_{Ref2} durch und stellt ausgangsseitig einen damit korrespondierenden digitalen Wert als Istwert zur Verfügung. Die Logikeinheit 5a des ersten, oberen Messkanals 2a empfängt diesen Istwert und überträgt ihn über die Verbindungsleitung 11 an die Logikeinheit 5b des zweiten Messkanals 2b. Die Logikeinheit 5b des zweiten Messkanals 2b führt dann einen Vergleich des Erwartungswerts mit dem Istwert durch, um die Funktion des ersten, oberen Messkanals 2a zu überprüfen. Wenn der Erwartungswert nicht mit dem Istwert übereinstimmt wird eine Abweichung der beiden Werte bestimmt. Abhängig von der Größe der Abweichung kann ein Fehler bei der Wandlung der zweiten Referenzspannung U_{Ref2} in dem A/D-Wandler 4a des ersten, oberen Messkanals 2a festgestellt werden, oder die Abweichung liegt in einem Toleranzbereich, in dem die Funktion des ersten, oberen Messkanals 2a nicht beeinträchtigt ist.

Die Überprüfung des zweiten Messkanals 2b geschieht analog zu der zuvor beschriebenen Überprüfung des ersten Messkanals 2a. Die obigen Ausführungen gelten entsprechend.

Eine zweite Ausführungsform der vorliegenden Erfindung ist unter Bezug auf Figur 3 als Abwandlung der ersten Ausführungsform vorgesehen. Die Abweichungen zur ersten Ausführungsform werden im Detail beschrieben, im Übrigen ist die zweite Ausführungsform als identisch zur ersten Ausführungsform anzusehen.

Der Unterschied der zweiten Ausführungsform gegenüber der ersten Ausführungsform besteht in der Erzeugung der Referenzspannungen U_{Ref1}, U_{Ref2}. Dazu weist jede Logikeinheit 5a, 5b einen hier nicht gezeigten Logikausgang auf, der mit einem Spannungsteiler 12 verbunden ist. Der Spannungsteiler 12 ist zwischen einer Versorgungsspannung Uv und einer Masse der Messvorrichtung 1 geschaltet und umfasst drei in Reihe geschaltete Widerstände 13. Die Referenzspannungen U_{Ref1}, U_{Ref2} werden jeweils zwischen zwei unterschiedlichen Widerständen 13 abgegriffen.

Zu zweien der Widerstände 13 ist jeweils ein Transistor 14 parallel geschaltet ist, so dass der Widerstandswert einer Gruppe aus Widerstand 13 und Transistor 14 abhängig von einem Steuereingang 15 des Transistors 14 variiert werden kann, um den Spannungsteiler 12 einzustellen. Die Steuereingänge 15 sind jeweils mit dem Logikausgang der Steuereinheit 5a, 5b verbunden. Dadurch können die Logikeinheiten 5a, 5b das Teilungsverhältnis des Spannungsteilers 12 verändern.

Zur Ansteuerung des Spannungsteilers 12 werden an den Logikausgängen der Logikeinheiten 5a, 5b analoge Spannungswerte bereitgestellt, die mit dem an der Logikeinheit 5a, 5b anliegenden digitalen Wert korrespondieren. Zur Bestimmung der Referenzspannungen U_{Ref1}, U_{Ref2} ist es daher für jede Logikeinheit 5a, 5b erforderlich, zusätzlich zu dem an ihm anliegenden digitalen Wert auch den an der jeweils anderen jede Logikeinheit 5b, 5a anliegenden digitalen Wert vor der Überprüfung des Messkanals 2a, 2b zu kennen. Dieser digitale Wert wird entsprechend über die Verbindungsleitung 11 zwischen den Logikeinheiten 5a, 5b übertragen. Aus beiden digitalen Werten kann die jeweilige Logikeinheit 5a, 5b den Erwartungswert für die Überprüfung eines Messkanals 2a, 2b bestimmen.

Zusätzlich wird wie zuvor beschrieben der digitale Wert für die jeweils an dem zu überprüfenden Messkanal 2a, 2b anliegende Referenzspannung U_{Ref1}, U_{Ref2}, also der Istwert, über die Verbindungsleitung 11 an die Logikeinheit 5b, 5a des jeweils anderen Messkanals 2b, 2a übertragen. Diese Logikeinheit 5b, 5a führt dann einen Vergleich des Erwartungswerts mit dem Istwert durch, um die Funktion des entsprechenden Messkanals 2a, 2b zu überprüfen. Wenn der Erwartungswert nicht mit dem Istwert übereinstimmt wird eine Abweichung der beiden Werte bestimmt. Abhängig von der Größe der Abweichung kann ein Fehler bei der Wandlung der Referenzspannung U_{Ref1}, U_{Ref2} in dem A/D-Wandler 4a, 4b des zu überprüfenden Messkanals 2a, 2b festgestellt werden, oder die Abweichung liegt in einem Toleranzbereich, in dem die Funktion des Messkanals 2a, 2b nicht beeinträchtigt ist.

**Bezugszeichenliste**

| | |
|---|---|
| Messvorrichtung | 1 |
| Messkanal | 2a, 2b |
| Multiplexer | 3a, 3b |
| A/D-Wandler | 4a, 4b |
| Logikeinheit | 5a, 5b |
| Eingangseinheit | 6a, 6b |
| Eingang | 7 |
| Ausgang | 8 |
| Steuerungseingang | 9 |
| D/A-Wandler | 10 |
| Verbindungsleitung | 11 |
| Spannungsteiler | 12 |
| Widerstand | 13 |
| Transistor | 14 |
| Steuereingang | 15 |
| | |
| Messspannung | U_{Mess1}, U_{Mess2} |
| Referenzspannung | U_{Ref1}, U_{Ref2} |
| Versorgungsspannung | Uᵥ |

## Patentansprüche

1. Messvorrichtung (1) mit wenigstens zwei Messkanälen (2a, 2b), jeder Messkanal (2a, 2b) umfassend:
- einen A/D-Wandler (4a, 4b) für die Umwandlung einer analogen Spannung in einen digitalen Spannungswert, und
- eine Logikeinheit (5a, 5b), die mit dem A/D-Wandler (4a, 4b) verbunden ist, um den digitalen Spannungswert zu empfangen,
**dadurch gekennzeichnet, dass**
wenigstens ein Messkanal (2a, 2b) als sicherer Messkanal (2a, 2b) mit einer hohen Zuverlässigkeit ausgeführt ist und einen Multiplexer (3a, 3b) aufweist, wobei
mit dem Multiplexer (3a, 3b) die analoge Spannung zwischen einer Messspannung (U_{Mess1}, U_{Mess2}) und einer Referenzspannung (U_{Ref1}, U_{Ref2}) umschaltbar ist, und
die Logikeinheit (5a, 5b) jedes sicheren Messkanals (2a, 2b) als Referenzerzeuger für wenigstens einen anderen sicheren Messkanal (2a, 2b) ausgeführt ist, um die Referenzspannung (U_{Ref1}, U_{Ref2}) bereitzustellen und den Multiplexer (3a, 3b) zwischen der Messspannung (U_{Mess1}, U_{Mess2}) und der Referenzspannung (U_{Ref1}, U_{Ref2}) umzuschalten, und
die Logikeinheit (5a, 5b) des wenigstens einen anderen sicheren Messkanals (2a, 2b) und der Referenzerzeuger miteinander verbunden und derart ausgeführt sind, dass ein digitaler Wert, der die Referenzspannung (U_{Ref1}, U_{Ref2}) repräsentiert, von dem Referenzerzeuger an die Logikeinheit (5a, 5b) des sicheren Messkanals (2a, 2b) übertragbar ist und die Logikeinheit (5a, 5b) des sicheren Messkanals (2a, 2b) ausgeführt ist, ihren digitalen Spannungswert mit einem übertragenen digitalen Wert zu vergleichen.

2. Messvorrichtung (1) nach Anspruch 1, wobei der Referenzerzeuger ausgeführt ist, die Referenzspannung (U_{Ref1}, U_{Ref2}) basierend auf einem Zufallswert bereitzustellen.

3. Messvorrichtung (1) nach einem der Ansprüche 1 oder 2, wobei wenigstens zwei Messkanäle (2a, 2b) als sichere Messkanäle (2a, 2b) ausgeführt sind und die Logikeinheit Logikeinheit (5a, 5b) wenigstens eines sicheren Messkanals (2a, 2b) als Referenzerzeuger für wenigstens einen anderen sicheren Messkanal (2a, 2b) ausgeführt ist.

4. Messvorrichtung (1) nach einem der Ansprüche 1 bis 3, wobei der Referenzerzeuger eine programmierbare Spannungsquelle für die Bereitstellung der Referenzspannung (U_{Ref1}, U_{Ref2}) umfasst.

5. Messvorrichtung (1) nach einem der Ansprüche 1 bis 4, wobei die Messvorrichtung (1) einen einstellbaren Spannungsteiler (12) umfasst und der Referenzerzeuger ausgeführt ist, durch Einstellung des Spannungsteilers (12) die Referenzspannung (U_{Ref1}, U_{Ref2}) bereitzustellen.

6. Messvorrichtung (1) nach Anspruch 5 in Verbindung mit Anspruch 3, wobei der Spannungsteiler (12) mehrfach einstellbar ist und eine Mehrzahl Referenzerzeuger ausgeführt ist, durch Einstellung des Spannungsteilers (12) die Referenzspannung (U_{Ref1}, U_{Ref2}) bereitzustellen.

7. Messvorrichtung (1) nach einem der vorhergehenden Ansprüche, wobei der Referenzerzeuger einen D/A-Wandler (10) umfasst und ausgeführt ist, an dem D/A-Wandler (10) die Referenzspannung (U_{Ref1}, U_{Ref2}) basierend auf einem digitalen Wert bereitzustellen.

8. Messvorrichtung (1) nach einem der vorhergehenden Ansprüche, wobei der Referenzerzeuger ausgeführt ist, die Referenzspannung (U_{Ref1}, U_{Ref2}) basierend auf dem an ihm anliegenden digitalen Wert bereitzustellen.

9. Messvorrichtung (1) nach einem der vorhergehenden Ansprüche, wobei die Logikeinheit des sicheren Messkanals (2a, 2b) und der Referenzerzeuger miteinander verbunden und derart ausgeführt sind, dass der digitale Spannungswert von der Logikeinheit (5a, 5b) des sicheren Messkanals (2a, 2b) an den Referenzerzeuger übertragbar ist und der Referenzerzeuger ausgeführt ist, den übertragenen digitalen Spannungswert mit einem digitalen Wert, der die Referenzspannung (U_{Ref1}, U_{Ref2}) repräsentiert, zu vergleichen.

10. Messvorrichtung (1) nach einem der vorhergehenden Ansprüche, wobei die Messvorrichtung (1) zwischen einem Normalmodus und einem Überprüfungsmodus umschaltbar ist, wobei die Messvorrichtung (1) ausgeführt ist, im Überprüfungsmodus wenigstens einen sicheren Messkanal (2a, 2b) zu überprüfen.

## Claims

1. A measuring device (1) having at least two measuring channels (2a, 2b), each measuring channel (2a, 2b) comprising:
- an A/D converter (4a, 4b) for converting an analogue voltage into a digital voltage value, and
- a logic unit (5a, 5b), which is connected to the A/D converter (4a, 4b) in order to receive the digital voltage value,
**characterised in that**
at least one measuring channel (2a, 2b) is designed as a secure measuring channel (2a, 2b) with a high reliability and has a multiplexer (3a, 3b),
wherein
the analogue voltage can be switched over by means of the multiplexer (3a, 3b) between a measuring voltage (U_{Mess1}, U_{Mess2}) and a reference voltage (U_{Ref1}, U_{Ref2}), and
the logic unit (5a, 5b) of each secure measuring channel (2a, 2b) is designed as a reference generator for at least one other secure measuring channel (2a, 2b) in order to provide the reference voltage (U_{Ref1}, U_{Ref2}) and switch the multiplexer (3a, 3b) between the measuring voltage (U_{Mess1}, U_{Mess2}) and the reference voltage (U_{Ref1}, U_{Ref2}), and
the logic unit (5a, 5b) of the at least one other secure measuring channel (2a, 2b) and the reference generator are connected to one another and are designed in such a way that a digital value, which represents the reference voltage (U_{Ref1}, U_{Ref2}), can be transferred from the reference generator to the logic unit (5a, 5b) of the secure measuring channel (2a, 2b), and the logic unit (5a, 5b) of the secure measuring channel (2a, 2b) is designed to compare its digital voltage value with a transferred digital value.

2. The measuring device (1) according to claim 1, wherein the reference generator is designed to provide the reference voltage (U_{Ref1}, U_{Ref2}) on the basis of a random value.

3. The measuring device (1) according to either one of claims 1 or 2, wherein at least two measuring channels (2a, 2b) are designed as secure measuring channels (2a, 2b) and the logic unit (5a, 5b) of at least one secure measuring channel (2a, 2b) is designed as a reference generator for at least one other secure measuring channel (2a, 2b).

4. The measuring device (1) according to any one of claims 1 to 3, wherein the reference generator comprises a programmable voltage source for providing the reference voltage (U_{Ref1}, U_{Ref2}).

5. The measuring device (1) according to any one of claims 1 to 4, wherein the measuring device (1) comprises an adjustable voltage divider (12) and the reference generator is designed to provide the reference voltage (U_{Ref1}, U_{Ref2}) by adjusting the voltage divider (12).

6. The measuring device (1) according to claim 5 in conjunction with claim 3, wherein the voltage divider (12) can be adjusted multiple times and a plurality of reference generators are designed to provide the reference voltage (U_{Ref1}, U_{Ref2}) by adjustment of the voltage divider (12).

7. The measuring device (1) according to any one of the preceding claims, wherein the reference generator comprises a D/A converter (10) and is designed to provide the reference voltage (U_{Ref1}, U_{Ref2}) to the D/A converter (10) on the basis of a digital value.

8. The measuring device (1) according to any one of the preceding claims, wherein the reference generator is designed to provide the reference voltage (U_{Ref1}, U_{Ref2}) on the basis of the digital value applied thereto.

9. The measuring device (1) according to any one of the preceding claims, wherein the logic unit of the secure measuring channel (2a, 2b) and the reference generator are connected to one another and are designed in such a way that the digital voltage value can be transferred from the logic unit (5a, 5b) of the secure measuring channel (2a, 2b) to the reference generator, and the reference generator is designed to compare the transferred digital voltage value with a digital value that represents the reference voltage (U_{Ref1}, U_{Ref2}).

10. The measuring device (1) according to any one of the preceding claims, wherein the measuring device (1) can be switched between a normal mode and an inspection mode, wherein the measuring device (1) is designed in the inspection mode to inspect at least one secure measuring channel (2a, 2b).

## Revendications

1. Dispositif de mesure (1) doté d'au moins deux canaux de mesure (2a, 2b), chaque canal de mesure (2a, 2b) comprenant :
- un convertisseur analogique / numérique (4a, 4b) destiné à la conversion d'une tension analogique dans une valeur de tension numérique, et
- une unité logique (5a, 5b) qui est reliée avec le convertisseur analogique / numérique (4a, 4b) afin de réceptionner la valeur de tension numérique,
**caractérisé en ce**
**qu'**au moins un canal de mesure (2a, 2b) est conçu sous forme d'un canal de mesure (2a, 2b) sécurisé avec une fiabilité élevée et présente un multiplexeur (3a, 3b), où
la tension analogique peut être commutée entre une tension de mesure (U_{Mess1}, U_{Mess2}) et une tension de référence (U_{Ref1}, U_{Ref2}) avec le multiplexeur (3a, 3b), et
l'unité logique (5a, 5b) de chaque canal de mesure (2a, 2b) sécurisé est conçue sous la forme d'un générateur de référence pour au moins un autre canal de mesure (2a, 2b) sécurisé afin de mettre au point la tension de référence (U_{Ref1}, U_{Ref2}) et commuter le multiplexeur (3a, 3b) entre la tension de mesure (U_{Mess1}, U_{Mess2}) et la tension de référence (U_{Ref1}, U_{Ref2}), et
l'unité logique (5a, 5b) de l'au moins un autre canal de mesure (2a, 2b) sécurisé et le générateur de référence sont reliés ensemble et sont conçus de telle façon qu'une valeur numérique qui représente la tension de référence (U_{Ref1}, U_{Ref2}) peut être transférée à l'unité logique (5a, 5b) du canal de mesure (2a, 2b) sécurisé et l'unité logique (5a, 5b) du canal de mesure (2a, 2b) sécurisé est conçue pour comparer sa valeur de tension numérique avec la valeur numérique transférée.

2. Dispositif de mesure (1) selon la revendication 1, dans lequel le générateur de référence est conçu pour mettre au point la tension de référence (U_{Ref1}, U_{Ref2}) sur la base d'une valeur aléatoire.

3. Dispositif de mesure (1) selon l'une des revendications 1 ou 2, dans lequel au moins deux canaux de mesure (2a, 2b) sont conçus sous forme de canaux de mesures (2a, 2b) sécurisés et l'unité logique (5a, 5b) d'au moins un canal de mesure (2a, 2b) sécurisé est conçue servant de générateur de référence pour au moins un autre canal de mesure (2a, 2b) sécurisé.

4. Dispositif de mesure (1) selon l'une des revendications 1 à 3, dans lequel le générateur de référence comprend une source de tension programmable pour la mise au point de la tension de référence (U_{Ref1}, U_{Ref2}).

5. Dispositif de mesure (1) selon l'une des revendications 1 à 4, où le dispositif de mesure (1) comprend un diviseur de tension (12) réglable et le générateur de référence est conçu pour mettre au point la tension de référence (U_{Ref1}, U_{Ref2}) par un réglage du diviseur de tension (12).

6. Dispositif de mesure (1) selon la revendication 5 en relation avec la revendication 3, dans lequel le diviseur de tension (12) est réglable de multiples manières et un générateur de référence de multiple est conçu pour mettre au point la tension de référence (U_{Ref1}, U_{Ref2}) par le réglage du diviseur de tension (12).

7. Dispositif de mesure (1) selon l'une des revendications précédentes, dans lequel le générateur de référence comprend un convertisseur numérique / analogique (10) et est conçu pour mettre au point la tension de référence (U_{Ref1}, U_{Ref2}) au niveau du convertisseur numérique / analogique (10) sur la base d'une valeur numérique.

8. Dispositif de mesure (1) selon l'une des revendications précédentes, dans lequel le générateur de référence est conçu pour mettre au point la tension de référence (U_{Ref1}, U_{Ref2}) sur la base de la valeur numérique lui étant adjacente.

9. Dispositif de mesure (1) selon l'une des revendications précédentes, dans lequel l'unité logique du canal de mesure (2a, 2b) sécurisé et le générateur de référence sont reliés ensemble et sont conçus de telle façon que la valeur de la tension numérique peut être transférée de l'unité logique (5a, 5b) du canal de mesure (2a, 2b) sécurisé vers le générateur de référence et le générateur de référence est conçu pour comparer la valeur de la tension numérique transférée avec une valeur numérique qui représente la tension de référence (U_{Ref1}, U_{Ref2}).

10. Dispositif de mesure (1) selon l'une des revendications précédentes, où le dispositif de mesure (1) peut être commuté entre un mode normal et un mode de vérification, où le dispositif de mesure (1) est conçu pour vérifier dans le mode de vérification au moins un canal de mesure (2a, 2b) sécurisé.
